# EUROPÄISCHE PATENTSCHRIFT

(11) **EP 3 601 154 B1**
(45) Veröffentlichungstag und Bekanntmachung des Hinweises auf die Patenterteilung: **11.11.2020**
(21) Anmeldenummer: 19722096.5
(22) Anmeldetag: 03.05.2019
(51) Int. Cl.: B81C 1/00

(54) **VERFAHREN ZUR HERSTELLUNG EINES WENIGSTENS TEILWEISE GEHÄUSTEN HALBLEITERWAFERS**
METHOD FOR PRODUCING AN AT LEAST PARTLY PACKAGED SEMICONDUCTOR WAFER
PROCÉDÉ SERVANT À FABRIQUER UNE TRANCHE SEMI-CONDUCTRICE AU MOINS EN PARTIE ENCAPSULÉE

(30) Priorität: 09.05.2018 DE 102018111200
(43) Veröffentlichungstag der Anmeldung: 05.02.2020
(73) Patentinhaber: United Monolithic Semiconductors GmbH, 89081 Ulm (DE)
(72) Erfinder: STIEGLAUER, Hermann, 89134 Blaustein (DE)
(74) Vertreter: Baur & Weber Patentanwälte PartG mbB
(86) Internationale Anmeldenummer: PCT/EP2019/061359
(87) Internationale Veröffentlichungsnummer: WO 2019/215027

(56) Entgegenhaltungen:
- FR-A1- 2 880 184
- US-A1- 2013 135 317
- GOSELE U ET AL: "Wafer bonding for microsystems technologies", SENSORS AND ACTUATORS A: PHYS, ELSEVIER BV, NL, Bd. 74, Nr. 1-3, 20. April 1999 (1999-04-20), Seiten 161-168, XP004188079, ISSN: 0924-4247, DOI: 10.1016/S0924-4247(98)00310-0

## Beschreibung

Die Erfindung betrifft ein Verfahren zur Herstellung eines wenigstens teilweise gehäusten Halbleiterwafers.

Aus dem allgemeinen Stand der Technik ist es bekannt, Halbleitersubstrate mittels dauerhafter chemischer Verbindungen miteinander zu verbinden. Derartige Verfahren werden typischerweise anodisches, direktes oder eutektisches Bonden genannt. Bekanntlich werden derartige Verfahren in der Elektronikindustrie zur Herstellung von optischen und elektrischen Bauteilen verwendet, um durch das Anbringen eines Gehäuses die Bauteile vor Umwelteinflüssen zu schützen. Desweiteren wird in dem Gebiet der Mikrosystemtechnik das Waferbonden genutzt, um beispielsweise für Sensoren benötigte Kavitäten herzustellen. Dies kann z. B. eine Referenzdruckkammer bei einem absoluten Drucksensor oder eine Unterdruckkammer bei einem Drehratensensor umfassen.

Nachteilig ist jedoch, dass derartige Verfahren typischerweise einen Temperaturschritt beinhalten, der beispielsweise 200°C betragen und bis zu 500°C reichen kann. Desweiteren werden die zu verbindenden Haltleitersubstrate Druckkräften ausgesetzt und es müssen Zwischenschichten gebildet werden. Im Einzelfall ist auch die Beaufschlagung mit elektrischen Feldern vorgesehen. Folglich sind das anodische und das direkte Bonden stark von den Materialeigenschaften der Substrate abhängig, was die Anwendung auf neue Produkte erheblich einschränkt. Zudem wird beim eutektischen Bonden die Abscheidung von dünnen Metallschichten vorgenommen, was mit hohem Aufwand verbunden ist.

Insbesondere bei der Verwendung im Bereich von Hochfrequenzbauteilen oder auf dem Gebiet der Leistungselektronik werden oftmals Verbindungshalbleiter eingesetzt, die eine sehr hohe Isolationseigenschaft besitzen und demnach herkömmlichen Waferbonding-Verfahren nicht offen stehen. Auch können in Verbindungshalbleitern die beim eutektischen Bonden notwendigen hohen elektrischen Felder zur Schädigung der Bauteile durch Entladungseffekte führen.

Eine weitere Möglichkeit könnte darin bestehen, unterschiedliche Halbleiter mit adhäsiven Bonden zu verbinden, wobei hier jedoch Klebstoff als Zwischenschicht verwendet werden muss. Ein derartiges Verfahren ist jedoch aufwändig, wobei insbesondere die Herstellung von Klebstoff als Zwischenschicht auch bei Verbindungshalbleitern nicht unproblematisch ist.

Aus der US 2013/0135317 A1 ist ein in Schichten aufgebautes mikroelektromechanisches System (Englisch: microelectromechanical system MEMS) bekannt, bei dem eine mit elektronischen Bauteilen versehene Substratschicht mit einer Glasplatte abgedeckt wird. Die Glasplatte wird durch Löten, Verkleben oder Thermokompressionsbonden mit der Substratschicht verbunden Im Falle des Verklebens umfasst das Verfahren u.a. die Schritte: Bereitstellen eines Halbleiterwafers mit Bauteilen auf seiner Oberseite, Bereitstellen einer Abdeckscheibe, deren Oberfläche den Halbleiterwafer wenigstens teilweise überdeckt, Zusammenführen der Oberseite des Halbleiterwafers und der Oberfläche der Abdeckscheibe, und Verbinden des Halbleiterwafers und der Abdeckscheibe, so dass die Abdeckscheibe ein Gehäuse des Halbleiterwafers bildet.

Aus der FR 2 880 184 ist ein Verfahren bekannt, bei dem eine Siliziumplatte, mit einer zweiten Platte verklebt wird, die aus Quarz-, SiC-, Saphir- oder aus substituiertem Silizium hergestellt ist, wobei die beiden Platten derart verklebt werden, dass ein Angriff chemischer Substanzen auf der ersten Platte in abgeklebten Bereichen unterbunden wird.

In Gösele et al "Wafer bonding for microsystems technologies", Sensors and Actuators, Band 74 (1999), Seiten 161-168 wird die Verbindung zweier Wafer mit aktivierten Oberflächen beschrieben.

Ausgehend von diesem Stand der Technik hat sich der Erfinder nun die Aufgabe gestellt, ein Verfahren zur Herstellung eines wenigstens teilweise gehäusten Halbleiterwafers zu schaffen, das die bisher auftretenden Probleme beim Verwenden des Waferbondens überwindet und eine zuverlässige Verbindung bei der Bildung eines Gehäuses auf einem Halbleiterwafer ermöglicht.

Diese Aufgabe wird durch die Merkmale des Patentanspruchs 1 gelöst. Vorteilhafte Weiterbildungen der Erfindung sind jeweils Gegenstand der Unteransprüche. Diese können in technologisch sinnvoller Weise miteinander kombiniert werden. Die Beschreibung, insbesondere im Zusammenhang mit der Zeichnung charakterisiert und spezifiziert die Erfindung zusätzlich.

Gemäß der Erfindung wird ein Verfahren zur Herstellung eines wenigstens teilweise gehäusten Halbleiterwafers geschaffen, bei dem nachfolgende Schritte ausgeführt werden. Zunächst wird ein Halbleiterwafer mit Bauteilen auf seiner Oberseite bereitgestellt. Ebenso wird eine Abdeckscheibe bereitgestellt, deren Oberfläche den Halbleiterwafer wenigstens teilweise überdeckt. Es erfolgt Funktionalisieren der Oberfläche der Abdeckscheibe zum Bilden einer funktionalen Schicht mittels einer Plasmabehandlung der Oberfläche der Abdeckscheibe. Sofort nach Aktivieren der funktionalen Schicht durch Bestrahlen mit Licht erfolgt das Zusammenführen der Oberseite des Halbleiterwafers und der Oberfläche der Abdeckscheibe zum chemischen Verbinden des Halbleiterwafers und der Abdeckscheibe, so dass die Abdeckscheibe ein Gehäuse des Halbleiterwafers bildet. Die Verbindung wird dabei dem englischen Sprachgebrauch folgend auch als aktives Oberflächenbonden oder "active surface bonding" bezeichnet.

Demnach wird ein Verfahren zur dauerhaften Verbindung zwischen dem Halbleiterwafer und der Abdeckscheibe mittels chemischer Bindung geschaffen, wobei die Herstellung eines Gehäuses erfindungsgemäß weder von den elektrischen Eigenschaften noch von der Materialzusammensetzung des Halbleitersubstrats bzw. der Abdeckscheibe abhängig ist. Demnach ist es möglich, die Anwendungsmöglichkeiten im Umfeld der Mikrosystemtechnik bzw. Halbleiterfertigung wesentlich auszudehnen und sowohl Gehäuse für integrierte Schaltungen als auch Anwendungen wie z. B. Kavitäten in der Mikrosystemtechnik zu schaffen. Die von der Erfindung vorgeschlagenen Verfahrensschritte führen zu einer Reduzierung der Herstellungskosten bei der Fertigung von Bauelementen der Mikrosystemtechnik oder integrierter Schaltungen und können darüber hinaus auch verbesserte elektrische Eigenschaften aufweisen.

Gemäß der Erfindung umfasst das Bilden der funktionalen Schicht eine Plasmabehandlung der Oberfläche der Abdeckscheibe.

Da im Gegensatz zum Halbleiterwafer die Abdeckscheibe typischerweise keine aktiven Bauelemente umfasst, wird die chemische Verbindung des Halbleiterwafers und der Abdeckscheibe bevorzugt über das Bilden der funktionalen Schicht auf der Oberfläche der Abdeckscheibe eingeleitet. Für eine dauerhafte Verbindung werden sowohl die Abdeckscheibe als auch der Halbleiterwafer zunächst gereinigt, wobei beide Scheiben eine mittlere Rauheit von 10 bis 20 nm oder weniger aufweisen sollen. Durch das Aussetzen der Oberfläche der Abdeckscheibe mit einem Plasma wird eine geordnete Schicht auf der Oberfläche der Abdeckscheibe gebildet, deren Eigenschaften durch Bestandteile des Plasmas bestimmt werden. Hierzu wird typischerweise ein Trägergas zu entsprechenden Elektroden transportiert und anschließend ionisiert. Die Ionen des Trägergases sind demnach für die Eigenschaften der funktionalen Schicht verantwortlich.

Gemäß einer weiteren Ausführungsform der Erfindung umfasst die Plasmabehandlung das Bewegen der Oberfläche der Abdeckscheibe unter einem Plasmastab, wobei Anzahl und Geschwindigkeit der Bewegungen der Abdeckscheibe unter dem Plasmastab eine Schichtdicke der funktionalen Schicht definiert.

Hierzu wird typischerweise die Plasmabehandlung an einem Plasmastab durchgeführt, wobei Elektroden des Plasmastabs für eine Ionisierung des Trägergases sorgen. Die dabei abgeschiedene funktionale Schicht auf der Oberfläche der Abdeckscheibe wird in Form von geordneten Molekülen aufgebracht. Dazu wird das Substrat unterhalb des Plasmastabs bewegt. Die Geschwindigkeit und die Anzahl der Durchgänge der Abdeckscheibe unterhalb des Plasmastabs definieren die Dicke der funktionalen Schicht.

Gemäß einer weiteren Ausführungsform der Erfindung umfasst das Aktivieren der funktionalen Schicht ein Bestrahlen mit Licht einer vorgegebenen Wellenlänge, vorzugsweise im UV-Bereich.

Nach der oben beschriebenen Behandlung der Oberfläche der Abdeckscheibe mit dem Plasmastab ist die abgeschiedene Schicht zunächst inaktiv. Der inaktive Zustand bleibt solange erhalten, bis die funktionale Schicht mit Licht beispielsweise im nahen UV-Bereich aktiviert wird. Durch Aktivierung und sofortiger Verbindung durch flächigen Kontakt mit dem Halbleiterwafer entstehen zwischen der Oberfläche der Abdeckscheibe und der Oberseite des Halbleiterwafers kovalente Bindungen zwischen den Molekülen der funktionalen Schicht und des Halbleiterwafers. Diese führen dann zu einer chemischen Verbindung zwischen dem Halbleiterwafer und der Abdeckscheibe, die dauerhaft ist.

Gemäß einer weiteren Ausführungsform der Erfindung werden die Prozessschritte in einer abgedichteten Prozesskammer durchgeführt, wobei während der Aktivierung der funktionalen Schicht und dem Zusammenfügen der Scheiben eine Zusammensetzung und ein Druck einer Gasatmosphäre einstellbar ist.

Demnach kann als Variante eine abgedichtete Prozesskammer mit Gaszuführung und Druckregulierung zum Einsatz kommen, so dass während der Aktivierung der funktionalen Schicht und dem chemischen Verbinden ein gewünschter Druck und eine gewünschte Gaszusammensetzung eingestellt werden kann. Dies ermöglicht definierte Gas- bzw. Druckzusammensetzungen in vorhandenen Kavitäten zwischen dem Halbleiterwafer und der Abdeckscheibe, die in dem so gebildeten Gehäuse hermetisch eingeschlossen sind.
Die Abdeckscheibe kann als Silizium-Wafer, als Halbleitersubstrat eines Verbindungshalbleiters, aus Quarz oder aus Glas bereitgestellt werden, wobei andere Materialien nicht ausgeschlossen sind.

Eine derartige Vorgehensweise ermöglicht die Herstellung unterschiedlichster Produkte aus der Mikrosystemtechnik, der Leistungselektronik oder der Hochfrequenzelektronik. Hierbei wird gleichzeitig ein hermetisches Gehäuse bereitgestellt, das vor Umwelteinflüssen, wie z. B. Feuchtigkeit schützt. Durch den Einschluss beispielsweise von Luft können darüber hinaus Leistungsverluste in der Hochfrequenzelektronik reduziert werden.

Gemäß einer weiteren Ausführungsform der Erfindung ist die Abdeckscheibe auf ihrer dem Halbleiterwafer zugewandten Oberseite strukturiert, so dass einzelne Bauteilgruppen auf der Oberseite des Halbleiterwafers in Kavitäten auf der Oberfläche der Abdeckscheibe angeordnet sind.

Wie bereits erwähnt, kann für einzelne oder auch alle Bauteilgruppen auf der Oberseite des Halbleiterwafers zur Reduzierung von Leistungsverlusten eine mit einem Gas gefüllte Kavität bereitgestellt werden, um die dielektrischen Verluste zu reduzieren. Ein derartiges Gehäuse kann sowohl für die Herstellung elektrischer Bauteile als auch in der Mikrosystemtechnik genutzt werden.

Gemäß einer weiteren Ausführungsform der Erfindung wird der Halbleiterwafer von der Seite gegenüberliegend zur Oberseite gedünnt und anschließend von dieser Rückseite kontaktiert.

Dieser an sich bekannte Rückseitenprozess erlaubt nun Bauteilegruppen auf der Oberseite des Halbleiterwafers mittels entsprechender Kontaktflächen auf der Rückseite mit elektrischen Anschlüssen zu versehen, die in nachfolgenden Prozessschritten als Anschlussflächen herangezogen werden können.

Gemäß einer weiteren Ausführungsform der Erfindung wird vorzugsweise mittels Sägen ein Vereinzeln einzelner Baugruppen, vorzugsweise entlang von Strukturelementen auf der Abdeckscheibe durchgeführt.

Gemäß dieser Vorgehensweise kann ein hermetisch gehäustes Bauteil geschaffen werden, das nach Vereinzelung der weiteren Verwendung zugeführt werden kann.

Hierbei können die Bauteile des Halbleiterwafers in Form von mikroelektronischen oder mikromechanischen Bauteilen bereitgestellt werden, die mit elektronischen Komponenten, vorzugsweise Hochfrequenz- oder Leistungselektronikkomponenten verbunden sind.

Gemäß einer weiteren Ausführungsform der Erfindung wird die Abdeckscheibe als Träger bei einer Rückseitenbearbeitung des Halbleiterwafers herangezogen.

Üblicherweise muss der Halbleiterwafer auf einen Träger temporär gebondet werden, um den Halbleiterwafer zu Dünnen und die Durchkontaktierungen im Halbleiterwafer herzustellen. Bei dieser Vorgehensweise ist das nicht mehr notwendig, da der Halbleiterwafer schon mit der Abdeckscheibe, die als Trägerwafer für die Rückseitenprozessierung dient, verwendet werden kann.

Nachfolgend werden einige Ausführungsbeispiele anhand der Zeichnung näher erläutert. Es zeigen:
- Fig. 1A: schematisch einen ersten Prozessschritt eines ersten Ausführungsbeispiels eines erfindungsgemäßen Verfahrens in einer Seitenansicht,
- Fig. 1B: einen zweiten Prozessschritt des ersten Ausführungsbeispiels in einer Seitenansicht,
- Fig. 1C: einen dritten Prozessschritt des ersten Ausführungsbeispiels in einer Seitenansicht,
- Fig. 2A: einen ersten Prozessschritt eines erfindungsgemäßen Verfahrens nach einem zweiten Ausführungsbeispiel in einer Seitenansicht,
- Fig. 2B: einen zweiten Prozessschritt des zweiten Ausführungsbeispiels in einer Seitenansicht,
- Fig. 2C: einen dritten Prozessschritt des zweiten Ausführungsbeispiels in einer Seitenansicht,
- Fig. 3A: einen weiteren Prozessschritt des erfindungsgemäßen Verfahrens in einer Seitenansicht,
- Fig. 3B: einen weiteren Prozessschritt des erfindungsgemäßen Verfahrens in einer Seitenansicht.

In den Figuren sind gleiche oder funktional gleich wirkende Bauteile mit den gleichen Bezugszeichen versehen.

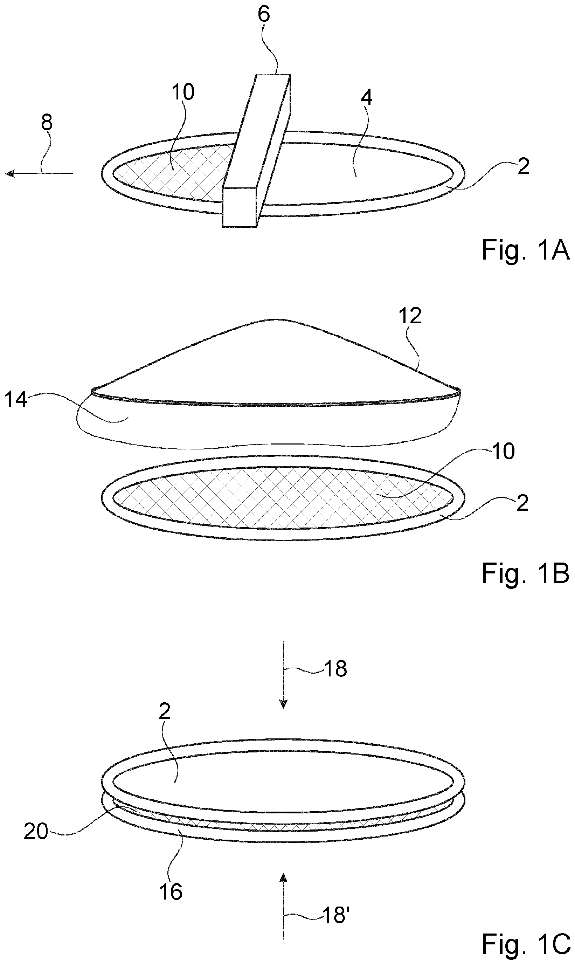

Unter Bezugnahme auf die Fig. 1A bis 1C wird nachfolgend eine erste Ausführungsform eines erfindungsgemäßen Verfahrens zur Herstellung eines gehäusten Halbleiterwafers beschrieben. Gemäß Fig. 1A ist gezeigt, dass eine Abdeckscheibe 2 bereitgestellt wird, deren Oberfläche 4 typischerweise den Abmessungen eines Halbleiterwafers entspricht. In anderen Ausführungsformen kann es jedoch auch vorgesehen sein, die Größe der Abdeckscheibe 2 beispielsweise kleiner zu wählen, so dass ein Halbleiterwafer nur teilweise überdeckt wird. Auf der Oberfläche 4 der Abdeckscheibe 2 ist ein Plasmastab 6 angeordnet, der den Bereich zwischen der Oberfläche 4 und dem Plasmastab 6 mittels geeigneter Elektroden ionisieren kann, so dass ein nicht in Fig. 1A gezeigtes Trägergas ionisiert und anschließend auf der Oberfläche 4 abgeschieden wird. Folglich bildet sich, sofern wie in Fig. 1 anhand des Richtungspfeils 8 gezeigt die Abdeckscheibe 2 ein- oder mehrfach unter dem Plasmastab 6 hindurchgezogen wird, eine funktionale Schicht 10, deren Dicke durch die Prozessführung, d. h. Anzahl und Geschwindigkeit der Durchgänge der Abdeckscheibe 2 unter dem Plasmastab 6 beeinflusst werden kann. Nachdem nun die funktionale Schicht 10 in der gewünschten Dicke erzeugt wurde, ist die funktionale Schicht 10 zunächst nach der Plasmabehandlung inaktiv.

Wie in Fig. 1B gezeigt ist, kann die funktionale Schicht 10, die vollflächig auf der Oberfläche 4 der Abdeckscheibe 2 gebildet ist, mittels Licht aus einer Lichtquelle 12 aktiviert werden. Die Lichtquelle 12, die beispielsweise Licht 14 im nahen UV-Bereich abgibt, bewirkt bei entsprechend gewählten Belichtungsbedingungen ein Aktivieren der funktionalen Schicht 10.

Im nächsten Schritt, wie in Fig. 1C dargestellt ist, wird nun ein Halbleiterwafer 16 bereitgestellt, wobei durch sofortiges Inkontaktbringen der Abdeckscheibe 2 und des Halbleiterwafers 16 ein Bondvorgang zwischen einer Oberseite 20 des Halbleiterwafers 16 und der funktionalen Schicht 10 der Abdeckscheibe 2 erzeugt wird, wobei durch den flächigen Kontakt kovalente Bindungen der aktivierten funktionalen Schicht und der Oberseite 20 des Halbleiterwafers 16 entstehen. Diese kovalenten Bindungen führen zu einer dauerhaften chemischen Verbindung der Abdeckscheibe 2 mit dem Halbleiterwafer 16. Das Kontaktieren der Abdeckscheibe 2 und des Halbleiterwafers 16 ist anhand der Verschieberichtungen 18 und 18' in Fig. 1C angedeutet.

Die im Zusammenhang mit den Fig. 1A bis 1C beschriebenen Prozessschritte können beispielsweise dazu verwendet werden, ein Gehäuse mittels der Abdeckscheibe 2 zu schaffen, das Bauteile (nicht in den Fig. 1A bis 1C gezeigt) auf der Oberseite 20 des Halbleiterwafers 16 bedecken. Dies entspricht dem Verkapseln beispielsweise von optischen oder elektronischen Bauteilen in der Elektronikindustrie.

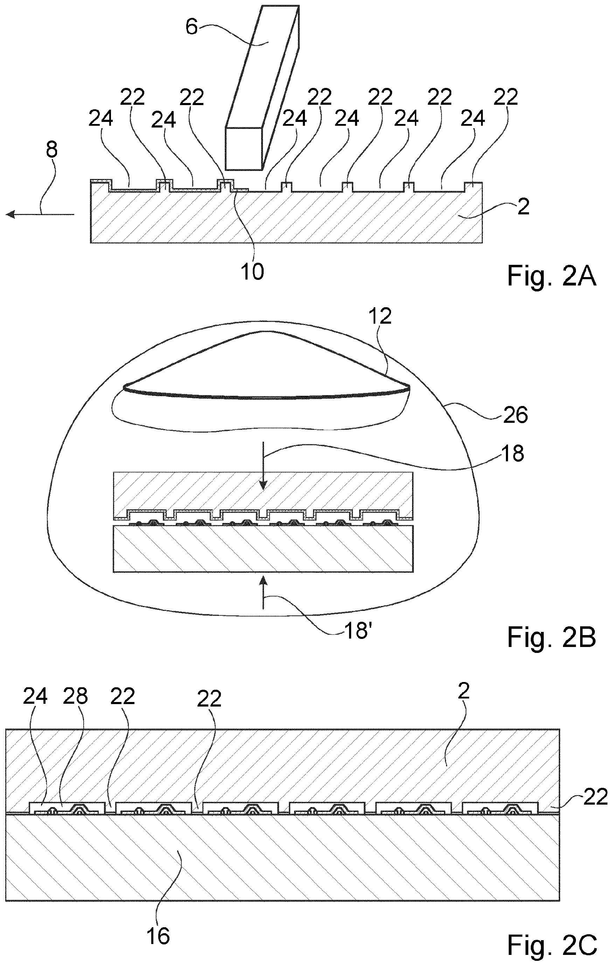

Unter Bezugnahme auf Fig. 2A bis 2C wird nachfolgend eine zweite Ausführungsform des erfindungsgemäßen Verfahrens beschrieben. Zur Verdeutlichung werden jedoch im Wesentlichen die Unterschiede zu dem im Zusammenhang mit Fig. 1A bis 1C beschriebenen Verfahren erläutert.

Wie Fig. 2A zu entnehmen ist, ist die Abdeckscheibe 2 auf ihrer Oberfläche 4 strukturiert, so dass entsprechende Strukturelemente 22 geschaffen wurden, zwischen denen Kavitäten 24 ausgebildet sind. Die Strukturierung mit den Strukturelementen 22 kann dabei in Form eines Gitters erfolgen. Mittels des Plasmastabs 6 wird wiederum durch Bewegung entlang des Richtungspfeils 8 die funktionale Schicht 10 gebildet. Die Aktivierung der funktionalen Schicht 10 erfolgt in einer Prozesskammer 26, in die die Abdeckscheibe 2, der Halbleiterwafer 16 und die Lichtquelle 12 angeordnet sind. Durch Zuführen eines gewünschten Gasgemisches bzw. Einstellen eines Drucks des Gasgemisches kann nach Aktivierung mittels der Lichtquelle 12 nunmehr durch Kontaktieren anhand der Bewegung entlang der Verschieberichtungen 18 und 18' ein chemischer Verbund aus Abdeckscheibe 2 und Halbleiterwafer 16 geschaffen werden, bei dem im Bereich der Kavitäten 24 Gas mit einer gewünschten Zusammensetzung bzw. Dichte vorliegt.

Das Ergebnis dieser Prozessführung ist in Fig. 2 nochmals vergrößert dargestellt. Man erkennt, dass in den Kavitäten 24, die von den Strukturelementen 22 begrenzt werden, eine definierte Atmosphäre herrscht, so dass die mit den Bezugszeichen 28 angedeuteten Bauelemente von der definierten Gasatmosphäre in der Kavität 24 umgeben sind. Eine derartige Vorgehensweise kann sowohl in der Hochfrequenzelektronik zur Reduzierung der Leistungsverluste als auch in der Mikrosystemtechnik zur Herstellung von für Sensoren nötigen Kavitäten genutzt werden. So kann auf diese Weise beispielsweise eine Referenzdruckkammer bei einem absoluten Drucksensor oder eine Unterdruckkammer eines Drehratensensors bereitgestellt werden. In der Hochfrequenz- bzw. Leistungselektronik ist aufgrund der geringeren Dielektrizitätswerte ebenfalls eine mit Gas gefüllte Kavität vorteilhaft.

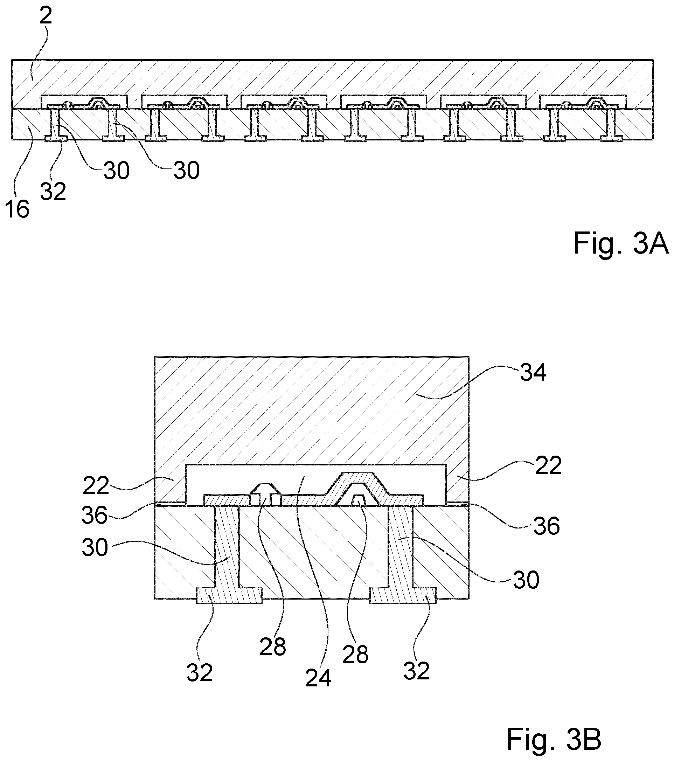

Weitere Verfahrensschritte werden nachfolgend unter Bezugnahme auf die Fig. 3A und 3B erläutert.

So ist in Fig. 3A gezeigt, dass der Halbleiterwafer 16 von einer der Oberseite 20 gegenüberliegenden Seite her gedünnt wird, so dass Rückseitenmetallisierungen und Kontakte gebildet werden können. Diese können die Bauelemente 28 über entsprechende Durchkontaktierungen 30 zu Rückseitenelektroden 32 führen.

Nach einem Vereinzeln, dessen Ergebnis vergrößert in Fig. 3B dargestellt ist, erhält man ein fertiges elektronisches Bauteil, das über das aus dem Material der Abdeckscheibe 2 gebildete Gehäuse 34 hermetisch gegen die Umwelt abgeschirmt und abgedichtet ist. Die Vereinzelung erfolgt dabei vorzugsweise so, dass die Strukturelemente 22 teilweise erhalten bleiben. Bereiche, in denen Verbindungen mittels des aktiven Oberflächenbondens hergestellt wurden, sind schematisch mit dem Bezugszeichen 36 in Fig. 3B angedeutet. Die Kavität 24 kann mit Gas gefüllt sein.

In anderen Verfahren kann die Abdeckscheibe 2 als Träger bei einer Rückseitenbearbeitung des Halbleiterwafers 16 herangezogen werden, um im Halbleiterwafer 16 Durchkontaktierungen herzustellen oder den Halbleiterwafer 16 zu dünnen.

Die Erfindung ist nicht auf die beschriebenen Ausführungsbeispiele beschränkt, sondern im Rahmen fachmännischen Könnens in mancherlei Weise abwandelbar.

### Liste der Bezugszeichen:

- 2: Abdeckscheibe
- 4: Oberfläche
- 6: Plasmastab
- 8: Richtungspfeil
- 10: funktionale Schicht
- 12: Lichtquelle
- 14: Licht
- 16: Halbleiterwafer
- 18: Verschieberichtungen
- 20: Oberseite
- 22: Strukturelemente
- 24: Kavität
- 26: Prozesskammer
- 28: Bauelemente
- 30: Durchkontaktierung
- 32: Rückseitenelektrode
- 34: Gehäuse
- 36: Verbindungsbereich

## Patentansprüche

1. Verfahren zur Herstellung eines wenigstens teilweise gehäusten Halbleiterwafers (16), umfassend die Schritte:
- Bereitstellen eines Halbleiterwafers (16) mit Bauteilen (28) auf seiner Oberseite (20);
- Bereitstellen einer Abdeckscheibe (2), deren Oberfläche (4) den Halbleiterwafer (16) wenigstens teilweise überdeckt,
- Funktionalisieren der Oberfläche (4) der Abdeckscheibe (2) zum Bilden einer funktionalen Schicht (10) mittels einer Plasmabehandlung der Oberfläche (4) der Abdeckscheibe (2),
- sofort nach Aktivieren der funktionalen Schicht (10) durch Bestrahlen mit Licht Zusammenführen der Oberseite (20) des Halbleiterwafers (16) und der Oberfläche (4) der Abdeckscheibe (2) zum chemischen Verbinden des Halbleiterwafers (16) und der Abdeckscheibe (2), so dass die Abdeckscheibe (2) ein Gehäuse des Halbleiterwafers (16) bildet.

2. Verfahren nach Anspruch 1, bei dem die Plasmabehandlung das Bewegen der Oberfläche (4) der Abdeckscheibe (2) unter einem Plasmastab (6) umfasst, wobei Anzahl und Geschwindigkeit der Bewegungen der Abdeckscheibe (2) unter dem Plasmastab (6) eine Schichtdicke der funktionalen Schicht (10) definiert.

3. Verfahren nach einem der Ansprüche 1 oder 2, bei dem das Aktivieren der funktionalen Schicht (10) ein Bestrahlen mit Licht (14) einer vorgegebenen Wellenlänge, vorzugsweise im UV-Bereich umfasst.

4. Verfahren nach einem der Ansprüche 1 bis 3, bei dem die Prozessschritte in einer abgedichteten Prozesskammer (26) durchgeführt werden, wobei während der Aktivierung der funktionalen Schicht (10) und dem Zusammenfügen der Scheiben (2, 16) eine Zusammensetzung und ein Druck einer Gasatmosphäre einstellbar ist.

5. Verfahren nach einem der Ansprüche 1 bis 4, bei dem die Abdeckscheibe (2) auf ihrer dem Halbleiterwafer (16) zugewandten Oberseite (20) strukturiert ist, so dass einzelne Bauteilgruppen auf der Oberseite (20) des Halbleiterwafers (16) in Kavitäten (24) auf der Oberfläche (4) der Abdeckscheibe (2) angeordnet sind.

6. Verfahren nach einem der Ansprüche 1 bis 5, bei dem der Halbleiterwafer (16) von der Seite gegenüberliegend zur Oberseite (20) gedünnt wird und anschließend von der Rückseite kontaktierbar ist.

7. Verfahren nach Anspruch 6, bei dem vorzugsweise mittels Sägen ein Vereinzeln einzelner Baugruppen, vorzugsweise entlang von Strukturelementen (22) auf der Abdeckscheibe (2) durchgeführt wird.

8. Verfahren nach einem der Ansprüche 1 bis 7, bei dem die Bauteile (28) des Halbleiterwafers (16) in Form von mikroelektronischen oder mikromechanischen Bauteilen bereitgestellt werden, die mit elektronischen Komponenten, vorzugsweise Hochfrequenz-Komponenten verbunden sind.

9. Verfahren nach einem der Ansprüche 1 bis 8, bei dem die Abdeckscheibe (2) als Träger bei einer Rückseitenbearbeitung des Halbleiterwafers (16) herangezogen wird.

## Claims

1. Method for producing an at least partially housed semiconductor wafer (16), comprising the steps of:
- providing a semiconductor wafer (16) having components (28) on its upper side (20);
- providing a cover plate (2), the surface (4) of which covers the semiconductor wafer (16) at least in part,
- functionalizing the surface (4) of the cover plate (2) to form a functional layer (10) by means of a plasma treatment of the surface (4) of the cover plate (2),
- immediately after activating the functional layer (10) by irradiation with light, joining the upper side (20) of the semiconductor wafer (16) and the surface (4) of the cover plate (2) for chemical bonding of the semiconductor wafer (16) and the cover plate (2), so that the cover plate (2) forms a housing of the semiconductor wafer (16).

2. Method according to claim 1, wherein the plasma treatment comprises moving the surface (4) of the cover plate (2) under a plasma rod (6), the number and speed of movements of the cover plate (2) under the plasma rod (6) defining a layer thickness of the functional layer (10).

3. Method according to either claim 1 or claim 2, wherein activating the functional layer (10) comprises irradiation with light (14) of a predetermined wavelength, preferably in the UV range.

4. Method according to any of claims 1 to 3, wherein the process steps are carried out in a sealed process chamber (26), a composition and a pressure of a gas atmosphere being adjustable during the activation of the functional layer (10) and the joining of the plates (2, 16).

5. Method according to any of claims 1 to 4, wherein the cover plate (2) is structured on its upper side (20) facing the semiconductor wafer (16), such that individual component groups on the upper side (20) of the semiconductor wafer (16) are arranged in cavities (24) in the surface (4) of the cover plate (2).

6. Method according to any of claims 1 to 5, wherein the semiconductor wafer (16) is thinned from the side opposite the upper side (20) and can then be contacted from the rear side.

7. Method according to claim 6, wherein individual assemblies are separated, preferably by means of sawing, preferably along structural elements (22) on the cover plate (2).

8. Method according to any of claims 1 to 7, wherein the components (28) of the semiconductor wafer (16) are provided in the form of microelectronic or micromechanical components which are connected to electronic components, preferably high-frequency components.

9. Method according to any of claims 1 to 8, wherein the cover plate (2) is used as a carrier during rear-side processing of the semiconductor wafer (16).

## Revendications

1. Procédé de fabrication d'une plaquette de semi-conducteur (16) au moins partiellement encapsulée, comprenant les étapes suivantes :
- fournir une plaquette de semi-conducteur (16) comportant des composants (28) sur son côté supérieur (20),
- fournir un disque de recouvrement (2) dont la surface (4) recouvre au moins partiellement la plaquette de semi-conducteur (16),
- fonctionnaliser la surface (4) du disque de recouvrement (2) pour former une couche (10) fonctionnelle par traitement par plasma de la surface (4) du disque de recouvrement (2),
- rapprocher, immédiatement après l'activation de la couche (10) fonctionnelle par exposition à la lumière, le côté supérieur (20) de la plaquette de semi-conducteur (16) et la surface (4) du disque de recouvrement (2) de façon à lier chimiquement la plaquette de semi-conducteur (16) et le disque de recouvrement (2), de sorte que le disque de recouvrement (2) forme un boîtier pour la plaquette de semi-conducteur (16).

2. Procédé selon la revendication 1, selon lequel le traitement par plasma comprend le déplacement de la surface (4) du disque de recouvrement (2) sous un barreau de plasma (6), le nombre et la vitesse des mouvements du disque de recouvrement (2) sous le barreau de plasma (6) définissant une épaisseur de la couche (10) fonctionnelle.

3. Procédé selon l'une des revendications 1 ou 2, selon lequel l'activation de la couche (10) fonctionnelle comprend une exposition à une lumière (14) d'une longueur d'onde prédéterminée, de préférence dans le domaine de l'UV.

4. Procédé selon l'une des revendications 1 à 3, selon lequel les étapes de processus sont réalisées dans une chambre de traitement (26) étanche, une composition et une pression d'une atmosphère gazeuse pouvant être réglées lors de l'activation de la couche (10) fonctionnelle et de l'assemblage des disques (2, 16).

5. Procédé selon l'une des revendications 1 à 4, selon lequel le disque de recouvrement (2) est structuré sur son côté supérieur (20) tourné vers la plaquette de semi-conducteur (16), de sorte que des groupes de composants individuels sur le côté supérieur (20) de la plaquette de semi-conducteur (16) sont disposés dans des cavités (24) sur la surface (4) du disque de recouvrement (2).

6. Procédé selon l'une des revendications 1 à 5, selon lequel la plaquette de semi-conducteur (16) est amincie du côté opposé au côté supérieur (20), et peut ensuite être mise en contact depuis le côté arrière.

7. Procédé selon la revendication 6, selon lequel il est réalisé une séparation, de préférence par sciage, d'ensembles individuels, de préférence le long d'éléments structuraux (22) sur le disque de recouvrement (2).

8. Procédé selon l'une des revendications 1 à 7, selon lequel les composants (28) de la plaquette de semi-conducteur (16) se présentent sous la forme de composants microélectroniques ou micromécaniques qui sont reliés à des composantes électroniques, de préférence des composantes haute fréquence.

9. Procédé selon l'une des revendications 1 à 8, selon lequel le disque de recouvrement (2) est utilisé comme support pendant le traitement du côté arrière de la plaquette de semi-conducteur (16).
